# EUROPEAN PATENT APPLICATION

(11) **EP 3 300 388 A1**
(43) Date of publication of application: **28.03.2018**
(21) Application number: 16190748.0
(22) Date of filing: 27.09.2016
(51) Int. Cl.: H04R 3/00, H04R 9/06, H04R 29/00

(54) **MOBILE DEVICE AND SYSTEM COMPRISING A LOUDSPEAKER AND AN AMPLIFYER**

(71) Applicant: Sound Solutions International Co., Ltd., Beijing 100176 (CN)
(72) Inventor: REINING, Friedrich, 1160 Vienna (AT)
(74) Representative: Burger, Hannes

(57) **Abstract**

The invention relates to a system (21) which comprises a loudspeaker (31), an amplifier (23), a position measuring device (50), a receiving device (29), and a sending device (34). The loudspeaker (31) comprises a magnet system (41), a membrane (32) movably mounted with respect to the magnet system (41), and a voice coil (33) attached to the membrane (32). The magnet system (41) comprises a magnet (43) and the voice coil (33) is operatively coupled with the magnet (43). The amplifier (23) is connected to the voice coil (33) by means of electrical leads (28) and is configured to drive the loudspeaker (31) by applying an electric signal to the voice coil (33). The position measuring device (50) is configured to generate a position signal indicative of the current position of the membrane (32) with respect to the magnet (43) during operation of the loudspeaker (21), or is configured to have a varying electric property indicative of the current position of the membrane (32) with respect to the magnet (43) during operation of the loudspeaker (23). The sending device (34) is coupled to the position measuring device (50), is coupled to the electric leads (28) and is configured to generate and to send a signal via the electric leads (28) to the receiving device (29) in response to the position signal or the electric property. The signal comprises an information about the current position of the membrane (32) with respect to the magnet (43), the receiving device (29) is configured to extract the information about the current position of the membrane (32) with respect to the magnet (43) from the signal, and the amplifier (23) is configured to generate the electric signal in response to the extracted information about the current position of the membrane (32) with respect to the magnet (43).

## Description

The invention relates to a system comprising a loudspeaker and an amplifier driving the loudspeaker. The invention also relates to a mobile device, such as a mobile phone, comprising a loudspeaker and an amplifier driving the loudspeaker.

A loudspeaker usually comprises a magnet system, a membrane movably mounted with respect to the magnet system, and a voice coil attached to the membrane. The magnet system comprises a magnet and the voice coil is operatively coupled with the magnet. While operating, the amplifier drives the loudspeaker by applying an electric voltage to the voice coil, resulting in moving the membrane with respect to the magnet and in response to the electric voltage.

When there is no voltage signal applied to the voice coil, the membrane should be in a centered position. Due to, for instance, manufacturing tolerances or with time, the membrane may be displaced from this centered position, potentially resulting in a decreased performance of the loudspeaker. For instance, the displacement offset may cause distortion or limit the maximal excursion of the membrane.

It is an object of the present invention to provide an improved system which comprises a loudspeaker and an amplifier driving the loudspeaker.

It is a further object of the present invention to provide an improved mobile device, for instance, a mobile phone having an improved system comprised of a loudspeaker and an amplifier driving the loudspeaker.

The first object of the invention is achieved by means of a system, comprising:
a loudspeaker, which comprises a magnet system, a membrane movably mounted with respect to the magnet system, and a voice coil attached to the membrane, the magnet system comprising a magnet and the voice coil being operatively coupled with the magnet,
an amplifier connected to the voice coil by means of electrical leads and configured to drive the loudspeaker by applying an electric signal to the voice coil,
a position measuring device configured to generate a position signal indicative of the current position of the membrane with respect to the magnet during operation of the loudspeaker, or configured to have a varying electric property indicative of the current position of the membrane with respect to the magnet during operation of the loudspeaker,
a receiving device, and
a sending device coupled to the position measuring device, coupled to the electric leads and configured to generate and to send a signal via the electric leads to the receiving device in response to the position signal or the electric property, the signal comprising an information about the current position of the membrane with respect to the magnet, the receiving device being configured to extract the information about the current position of the membrane with respect to the magnet from the signal, and the amplifier being configured to generate the electric signal in response to the extracted information about the current position of the membrane with respect to the magnet.

The second object of the invention is achieved by means of a mobile device, such as a mobile phone, comprising the system according to the invention.

The loudspeaker may, for instance, be a micro loudspeaker.

The system comprises the amplifier and the loudspeaker. The amplifier may be of any design. Preferably, the amplifier is a class D amplifier.

The loudspeaker comprises the magnet system and the membrane. The membrane is movably mounted with respect to the magnet system as it is *per se* known in the art. The loudspeaker comprises the voice coil which is fixed to membrane. The magnet system comprises the magnet and the voice coil is operatively coupled with the magnet.

The amplifier, in particular an output of the amplifier is connected to the loudspeaker, specifically to the voice coil by means of the electric leads. In operation, the amplifier drives the loudspeaker by applying the electric signal to the voice coil. The electric signal is in particular an electric voltage. Then, an electric current flows through the voice coil. Due to the magnet and the current flowing through the voice coil, the membrane moves in response to the electric signal.

The system further comprises the position measuring device configured to generate a position signal indicative of the current position of the membrane with respect to the magnet during operation of the loudspeaker. Alternatively, the position measuring device may be configured to have an electric property indicative of the current position of the membrane with respect to the magnet during operation of the loudspeaker. The position measuring device is particularly a membrane position tracking system and allows to track the current position of the membrane with respect to the magnet or the magnet system during normal system operation.

The amplifier is configured to generate the electric signal for driving the loudspeaker in response to information about the current position of the membrane with respect to the magnet. By utilizing this information, the amplifier can modify the electric signal, potentially improving the overall sound quality of the system. For instance, the amplifier may add a d.c. offset to the electric signal in order to at least partly compensate a detected displacement of the membrane with respect to its desired position with respect to the magnet in response to the extracted information in particular with respect to a certain time-frame.

In order to obtain the extracted information, the system comprises the sending device and the receiving device. The sending device is coupled to the position measuring device and to the electric leads, and is configured to send a signal via the electric leads to the receiving device in response to the position signal or the electric property. This signal comprises an information about the current position of the membrane with respect to the magnet. The receiving device is configured to receive this signal and extract the information about the current position of the membrane with respect to the magnet from the signal for further processing by the amplifier.

As a result, the system does not need further leads to convey the relevant information from the loudspeaker to the amplifier.

The receiving device may be a separate component or device. Preferably, the amplifier comprises the receiving device, i.e. the receiving device is incorporated or integrated into the amplifier.

The sending device and the receiving device may be of any suitable engineering design. In particular, the sending device may be configured to generate a modulated carrier signal as the signal. The modulated carrier signal comprises an information about the current position of the membrane with respect to the magnet. Then, the receiving device may be configured to demodulate the modulated carrier signal in order to extract the information about the current position of the membrane with respect to the magnet from the modulated carrier signal. Generally, any suitable signal modulation techniques can be utilized, such as digital modulation. The carrier signal can also be modulated using an analog or a hybrid modulation technique. Therefore, the information about the current position of the membrane with respect to the magnet may be coded into the signal. Then, the receiving device may be configured to extract the information by decoding this information from the signal.

In particular, the carrier signal has a frequency well above audible frequencies. The carrier signal may have a frequency above 20 kHz, for instance, in the ultrasonic range.

The sending device may be incorporated as a single device, for instance, as an integrated circuit, such as an ASIC.

The sending device may comprise an integrated circuit, such as an ASIC. The sending device may comprise at least one discrete electronic component connected to the integrated circuit. The discrete electronic component may, for instance, be a passive component and may in particular relatively bulky. The discrete component may, for instance, be a capacitor.

Preferably, the loudspeaker comprises the sending device, at least a part of the sending device, i.e. the sending device or at least its relevant part is integrated or incorporated into the loudspeaker. Preferably, the magnet system comprises the sending device, at least a part of the sending device, i.e. the sending device or its relevant part is integrated or incorporated into the magnet system.

The amplifier may be configured to generate and to deliver to the electric leads an electric power signal having a frequency greater than 20 kHz. Then, the system may comprise an electronic device, for instance an electronic circuitry connected to the electric leads and configured to generate a d.c. voltage from the electric power signal for supplying the sending device with electric energy. The electronic device may comprise at least one discrete electronic component, such as a capacitor which may be integrated into the loudspeaker or into the magnet system, i.e. the loudspeaker, in particular the magnet system may comprise the electronic device. The frequency of the power signal may differ from the frequency of the signal.

It is also possible that the sending device is configured to generate a d.c. voltage from the electric power signal for its supplying with electric energy.

Preferably, the frequency of the power signal is greater than the frequency of the signal, in particular greater than the frequency of the modulated carrier signal.

The position measuring device may be of any suitable engineering design, for, instance, capacitive or inductive. Preferably, the loudspeaker comprises the position measuring device, i.e. the position measuring device is incorporated or integrated into the loudspeaker.

Preferably, the position measuring device comprises a capacitive device whose electric capacity as the electric property is indicative of the current position of the membrane with respect to the magnet. The capacitive device may, for instance, comprise a first plate electrode fixed to the magnet system or to the magnet, and a second plate electrode fixed to the membrane and operatively coupled with the first plate electrode. The electrode plates form a plate capacitor. Since the second plate electrode moves with the membrane, the distance between the two electrodes changes, resulting in an electric capacitance being indicative of the current position of the membrane with respect to the magnet.

The capacitive membrane position measuring device, for example, allows for an online monitoring that can be used to detect and compensate dynamic offset as well as to exceed the standard limits of excursion by making use of individual limit settings.

The magnet system may comprise a pot made from metal and a top plate made from metal. The pot may comprise side wall sections and a bottom wall section. The magnet may comprise a bottom side and a top side. Then, the magnet may be attached to the bottom wall section of the pot with its bottom side. The top plate may be attached to top side of the magnet. Preferably, the top plate covers the entire top side of the magnet. The magnet and the side wall sections form an air gap operatively coupled with the voice coil. The voice coil may at least partly be located within the air gap in order to be operatively coupled with the magnet. The side wall sections may be combined into a single side wall section.

If the position measuring device comprises the two plate electrodes, then the first plate electrode may be attached to the top side of the magnet. Preferably, the top plate comprises an aperture which surrounds the first plate electrode.

The top plate may comprise a slit shaped aperture joining the aperture surrounding the first plate electrode, preferably running to a side area of the top plate and surrounding at least one of further electric leads connecting the first plate electrode to the sending device or at least a part of the sending device, allowing to integrate the sending device relatively easily into the magnet system. If the sending device comprises the integrated circuit, then the slit shaped aperture may surround the integrated circuit.

The top plate, the top side and the bottom side of the magnet may have a rectangular or quadratic shape. Then, the first plate electrode may be attached centrally to the top side of the magnet. Then, the aperture of the top plate may be located centrally with respect to the top plate.

The rectangular or quadratic shaped magnet comprises corner regions. Preferably, the slit shaped aperture of the top plate extends to one of the corners of the top plate and joining the aperture.

At least the corner of the magnet associated with the slit shaped aperture may be chamfered. Then, the sending device or at least a part of the sending device may be attached to the magnet in the area of its chamfered corner. If applicable, then the discrete electronic component of the sending device may be attached to the magnet in the area of its chamfered corner.

The system, in particular the loudspeaker may comprise an inductor connected between the sending device and the voice coil. The additional inductor suppresses at least partly a frequency spectrum which cannot be sensed by humans, potentially reducing the risk to overheat the loudspeaker due to that frequency spectrum, and, thus, potentially increasing reliability of the entire system or the mobile device.

For an improved operation of the entire system, the system may comprise a voltage current sense device configured to sense the voltage and current of the electric leads, in particular at an output of the amplifier. Then, the amplifier may be configured to generate the electric signal in response to the sensed voltage and current.

Preferably, the amplifier comprises the voltage current sense device, i.e. the voltage current sense device is integrated into the amplifier. Then, the amplifier is preferably a so called smart amplifier, utilizing the back emf from the voice coil.

Depending on the embodiment, the system comprises membrane position tracking and, if applicable, coding the information about the current position of the membrane with respect to the magnet particularly in a frequency range well above the audio signal but still in the range of the amplifier onto the electrical leads connecting the amplifier with the voice coil. Preferably, a voltage and current sense is utilized. Then, this sensing device may include the receiving device. The receiving device may decode the signal and, hence, recover the information about the current position from the electric leads, i.e. a two wire connection between the loudspeaker and the amplifier.

Powering the position measuring device may be realized via the same wires preferably in another frequency range.

Depending on the specific embodiment, the system may split the frequency band into two main parts, namely an audio spectrum for the loudspeaker and an ultrasonic spectrum for the sending and receiving devices.

Yet in another embodiment, the coding of the current membrane position may be realized in a time division multiple access manner in general known to the skilled person in the art. Then, the sending and receiving devices may be synchronized to a certain timeslot pattern.

Yet in another embodiment the coding of the current membrane position may be realized in a combination of time division multiple access manner and code division multiple access. Then, the receiving and sending devices may be synchronized to a certain timeslot pattern and apply certain coding techniques to maximize the transfer quality.

### BRIEF DESCRIPTION OF THE DRAWINGS

FIG. 1 is a top view of a mobile phone;
FIG. 2 is schematic diagram of a system comprising an amplifier and a loudspeaker;
FIG. 3 is an amplitude diagram and a schematic diagram of the loudspeaker;
FIG. 4 is a perspective view of a magnet system of the loudspeaker;
FIG. 5 is a perspective view of a pot and a magnet of the magnet system;
FIG. 6 is a perspective view of the pot, the magnet and a top plate of the magnet system; and
FIG. 7 is a top view of the magnet system and a voice coil of the loudspeaker.

### DESCRIPTION OF THE PREFERRED EMBODIMENT

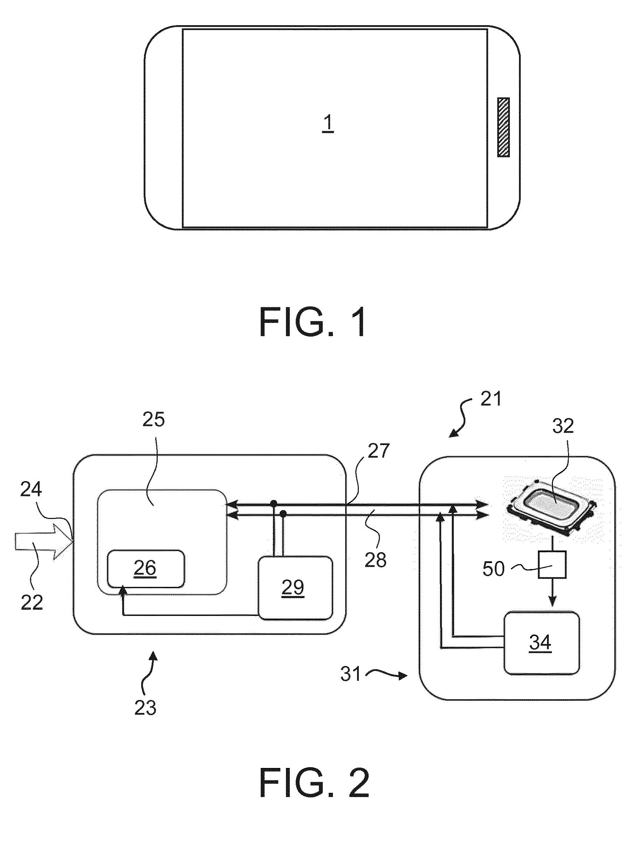

FIG. 1 shows a mobile phone 1 as an example of a mobile device. The mobile phone 1 comprises a microphone, a wireless sender-receiver unit and a loudspeaker-amplifier system 21 shown in Fig. 2. When, for instance, a person talks with another person utilizing the mobile phone 1, speech signals are received by the sender-receive unit, processed by a central processing unit of the mobile phone 1 and inputted as input signals 22 into the system 21.

The system 21 comprises an amplifier 23 and a loudspeaker 31.

The amplifier 23 may be of any suitable design. Preferably, the amplifier is a class D amplifier.

The amplifier 23 may comprise an input 24 for receiving the input signals, an amplification stage 25 a control unit 26 and an output 27.

The amplifier 23 and the loudspeaker 31 are connected via electric leads 28. The electric leads 28 may be connected with one of its ends to the output 27 of the amplifier 23.

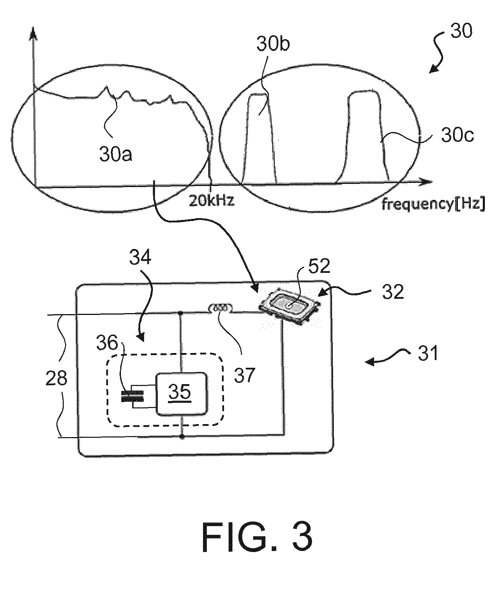

Fig. 3 shows a frequency diagram 30 to be described below and a more detailed schematic diagram of the loudspeaker 31 of the present preferred embodiment.

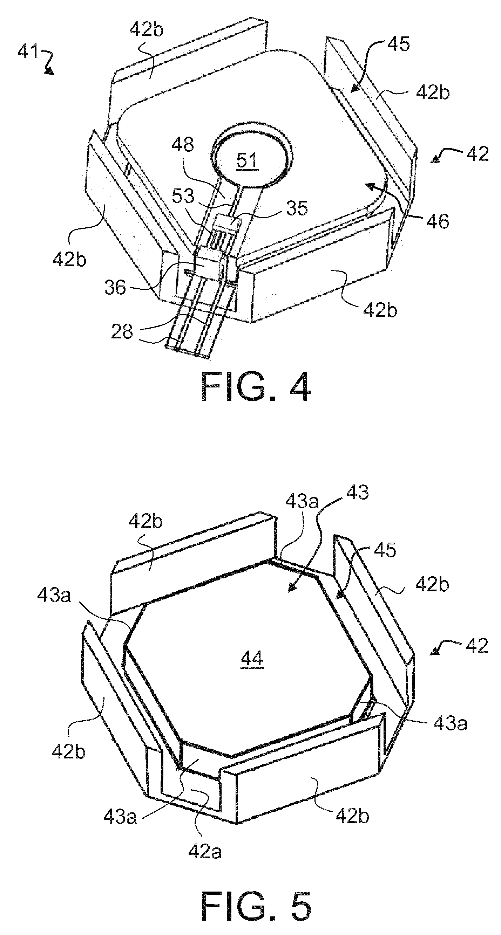

The loudspeaker 31 may comprise a magnet system 41 shown in Fig. 4, and a membrane 32 movably mounted with respect to the magnet system 41.

For the present embodiment, the magnet system 41 comprises a pot 42 made from metal and a magnet 43 attached to the pot 42. A perspective view of the pot 42 and the magnet 43 is shown in Fig. 5.

The magnet 43 may have a rectangular or quadratic shape and may have corner regions 43a. At least one of the corner regions 43a may be chamfered as shown in Fig. 5. In the present embodiment, all four corner regions 43a are chamfered.

The magnet 43 comprises a top side 44 and a bottom side.

The pot 42 may comprise a bottom wall section 42a and side wall sections 42b. the magnet 43 is attached with its bottom side to the bottom wall section 42a of the pot 42. Then, the magnet 43 and the side wall sections 42b form an air gap 45. The side wall sections 42b may be combined into a single side wall section.

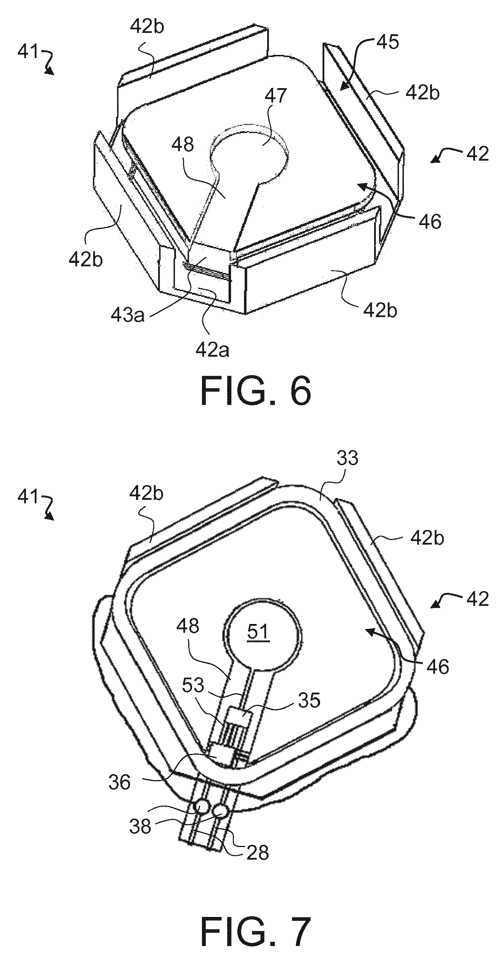

The magnet system 41 comprises a top plate 46 which is attached to the top side 44 of the magnet 43. The top plate 46 is made from metal and covers the magnet 43. A perceptive view of the pot 42, the magnet 43 and the top plate 46 is shown in Fig. 6.

The top plate 46 may have a rectangular or quadratic shape. For the present embodiment, the top plate 46 comprises an aperture 47 which may be of a circular shape and may be placed centrally. The top plate 46 may also comprise a slit-shaped aperture 48 joining the aperture 47 and running up to a side area of the top plate 46. For the present embodiment, the slit-shaped aperture 48 runs up to one of the corners of the top plate 46.

The loudspeaker 31 comprises the membrane 32 and a voice coil 33 attached to the membrane 32. The voice coil 33 is shown in Fig. 7. The membrane 32 is movably mounted with respect to the magnet system 41, particularly with respect to the magnet 43. The voice coil 33 is operatively coupled with the magnet 43. The voice coil 33 is at least partly be located within the air gap 45 in order to be operatively coupled with the magnet 43.

FIG. 7 also shows an electric connection 38 connecting the voice coil 33 to the electric leads 28. In order to see the voice coil 33 better, two of the side wall sections 42b are omitted in FIG. 7.

The system 21 comprises a position measuring device 50 configured to generate a position signal indicative of the current position of the membrane 32 with respect to the magnet 43 during operation of the loudspeaker 31, or configured to have a varying electric property indicative of the current position of the membrane 32 with respect to the magnet 43 during operation of the loudspeaker 31.

For the example embodiment shown in the figures, loudspeaker 31 comprises the position measuring device 50, i.e. the position measuring device 50 is integrated into the loudspeaker 31.

For the present embodiment, the position measuring device 50 comprises a first plate electrode 51 fixed to the magnet system 41, in particular to the magnet 43, and a second plate electrode 52 fixed to the membrane 32. The two plate electrodes 51, 52 are operatively coupled with each other. Preferably, the first plate electrode 52 is attached to the top side 44 of the magnet 43 and the aperture 47 of the top plate 46 surrounds the first plate electrode 51.

The first plate electrode 51 and the second electrode plates 52 form a plate capacitor. Since the second plate electrode 52 is fixed to the membrane 32 and, thus, moves with the membrane 32 during operation of the loudspeaker 31, the electric capacitance of the plate capacitor is indicative of the current position of the membrane 32 with respect to the magnet 43.

The system 21 comprises a receiving device 29. The receiving device 29 may, as it is shown in Fig. 2, be integrated into the amplifier 23.

The system 21 comprises a sending device 34 coupled to the position measuring device 50, coupled to the electric leads 28 and configured to generate and to send a signal via the electric leads 28 to the receiving device 29 in response to the position signal or the electric property. The signal comprises an information about the current position of the membrane 32 with respect to the magnet 43.

In the present example embodiment, the sending device 34 is connected to the two plate electrodes 51, 52 in order to obtain the information about the current position of the membrane 32 with respect to the magnet 43.

The receiving device 29 is configured to extract the information about the current position of the membrane 32 with respect to the magnet 43 from the signal.

The amplifier 23 is connected to the voice coil 33 by means of the electrical leads 28 and is configured to drive the loudspeaker 31 by applying an electric signal 30a to the voice coil 33.

The electric signal may have a frequency range up to 20 kHz but may also be extended to ultrasonic regions, if required.

The electric signal 30a is, for instance, an electric voltage.

The amplifier 23 is configured to generate the electric signal 30a in response to the extracted information about the current position of the membrane with respect to the magnet 43. The receiving device 29 is configured to extract the information about the current position of the membrane 32 with respect to the magnet 43 from the signal, and the amplifier 23 is configured to generate the electric signal 30a in response to the extracted information about the current position of the membrane 32 with respect to the magnet 43. Particularly, the receiving device 29 feeds the extracted information about the current position of the membrane 32 with respect to the magnet 43 to the control unit 26 which controls the amplification stage 25.

The sending device 34 preferably comprises an integrated circuit 35, for instance, an ASIC.

The sending device 34 is preferably integrated into the loudspeaker 31, preferably into its magnet system 41. In the present embodiment, the integrated circuit 35 of the sending device 34 is attached to the top side 44 of the magnet 43 and within the slit-shaped aperture 48.

The sending device 34 or the integrated circuit 35, respectively, may be located at the chamfered corner 43a associated with the slit-shaped aperture 48.

Figures 4 and 7 show further electric leads 53 which may be attached to the top side 44 of the magnet 43 and being placed within the slit-shaped aperture 48. The further electric leads 53 connect, for instance, the first plate electrode 51 with the sending device 34, in particular to the integrated circuit 35.

The sending device 34 and the receiving device 29 may be of any suitable engineering design.

In particular, the sending device 34 may be configured to generate a modulated carrier signal 30b as the signal. The modulated carrier signal 30b comprises the information about the current position of the membrane 32 with respect to the magnet 43. The receiving device 29 is configured to demodulate the modulated carrier signal 30b in order to extract the information about the current position of the membrane 32 with respect to the magnet 43 from the modulated carrier signal 30b. Generally, any suitable signal modulation techniques can be utilized, such as digital modulation. The carrier signal 30b can also be modulated using an analog or a hybrid modulation technique.

In particular, the carrier signal 30b has a frequency well above audible frequencies. The carrier signal 30b may have a frequency above 20 kHz, for instance in the ultrasonic range.

In the present embodiment, the amplifier 23 is configured to generate and to deliver to the electric leads 28 an electric power signal 30c having a frequency greater than 20 kHz.

The system 21 may comprise an electronic device, for instance an electronic circuitry connected to the electric leads 28 and configured to generate a d.c. voltage from the electric power signal for supplying the sending device 34 with electric energy. The electronic device may comprise at least one discrete electronic component, such as a capacitor which may be integrated into the loudspeaker 31 or into the magnet system 42, i.e. the loudspeaker 31, in particular the magnet system 42 may comprise the electronic device.

The sending device 34 may comprise at least one discrete electronic component, in particular at least one passive component connected to the integrated circuit 35. The passive component may, for instance, be a capacitor 36. Preferably, the capacitor 36 is integrated into the loudspeaker 31 or into its magnet system 41. The frequency of the power signal 30c differs from the frequency of the modulated carrier signal 30b. Preferably, the frequency of the power signal 30c is greater than the frequency of the modulated carrier signal 30b.

In the present embodiment, the capacitor 36 is located at the chamfered corner 43a associated with the slit-shaped aperture 48.

The system 21, in particular the loudspeaker 31 may comprise an inductor 37 connected between the sending device 34 and the voice coil 33. The additional inductor 37 suppresses at least partly a frequency spectrum which cannot be sensed by humans, potentially reducing the risk to over heat the loudspeaker 31 due to that frequency spectrum, and, thus, potentially increasing reliability of the entire system 21.

For an improved operation of the system 21, the system 21 may comprise a voltage current sense device configured to sense the voltage and current of the electric leads 28, in particular at an output 27 of the amplifier 23. Then, the amplifier 23 may be configured to generate the electric signal 30a in response to the sensed voltage and current. Preferably, the amplifier 23 comprises the voltage current sense device, i.e. the voltage current sense device is integrated into the amplifier 23. The voltage current sensing device and the receiving device 29 may be a single component.

Although modifications and changes may be suggested by those skilled in the art, it is the intention of the invention to embody within the patent warranted hereon all changes and modifications as reasonably and properly come within the scope of his contribution to the art.

## Claims

1. A system, comprising:
a loudspeaker (31), which comprises a magnet system (41), a membrane (32) movably mounted with respect to the magnet system (41), and a voice coil (33) attached to the membrane (32), the magnet system (41) comprising a magnet (43) and the voice coil (33) being operatively coupled with the magnet (43),
an amplifier (23) connected to the voice coil (33) by means of electrical leads (28) and configured to drive the loudspeaker (31) by applying an electric signal to the voice coil (33),
a position measuring device (50) configured to generate a position signal indicative of the current position of the membrane (32) with respect to the magnet (43) during operation of the loudspeaker (21), or configured to have a varying electric property indicative of the current position of the membrane (32) with respect to the magnet (43) during operation of the loudspeaker (23),
a receiving device (29), and
a sending device (34) coupled to the position measuring device (50), coupled to the electric leads (28) and configured to generate and to send a signal via the electric leads (28) to the receiving device (29) in response to the position signal or the electric property, the signal comprising an information about the current position of the membrane (32) with respect to the magnet (43), the receiving device (29) being configured to extract the information about the current position of the membrane (32) with respect to the magnet (43) from the signal, and the amplifier (23) being configured to generate the electric signal in response to the extracted information about the current position of the membrane (32) with respect to the magnet (43).

2. The system of claim 1, wherein the amplifier (23) comprises the receiving device (29), and/or wherein the loudspeaker (31) or the magnet system (41) comprises the sending device (34), and/or wherein the sending device (34) comprises an integrated circuit (35) and in particular at least one discrete electronic component (36) connected to the integrated circuit (35).

3. The system of claim 1 or 2, wherein the sending device (34) is configured to generate a modulated carrier signal as the signal, the modulated carrier signal comprising an information about the current position of the membrane (32) with respect to the magnet (43), and the receiving device (29) is configured to demodulate the modulated carrier signal in order to extract the information about the current position of the membrane (32) with respect to the magnet (43) from the modulated carrier signal.

4. The system of any of claims 1 to 3, wherein the amplifier (23) is configured to generate and to deliver to the electric leads (28) an electric power signal having a frequency greater than 20 kHz.

5. The system of any of claims 1 to 4, wherein the loudspeaker (31) comprises the position measuring device (50), in particular the position measuring device (50) comprising a capacitive device whose electric capacity as the electric property is indicative of the current position of the membrane with respect to the magnet.

6. The system of claim 5, wherein the capacitive device comprises a first plate electrode (51) fixed to the magnet system (41) or to the magnet (43), and a second plate electrode (51) fixed to the membrane (32) and operatively coupled with the first plate electrode (51), the first and second electrode plates (51, 52) forming a plate capacitor whose electric capacitance is indicative of the current position of the membrane (32) with respect to the magnet (43).

7. The system of any of claims 1 to 6, wherein the magnet (43) has a bottom side and a top side (44), the magnet system (41) comprising a pot (42) made from metal and a top plate (46) made from metal, the pot (42) comprising side wall sections (42b) and a bottom wall section (42a) attached to the bottom side of the magnet (43), the top plate (46) being attached to and covering the top side of the magnet (43), and the magnet (43) and the side wall sections (42b) forming an air gap (45) operatively coupled with the voice coil (33).

8. The system of claim 7, wherein the top plate (46) comprising an aperture (47), and the first plate electrode (51) being attached to the top side of the magnet (43) and being surrounded by the aperture (47) of the top plate (46).

9. The system of claim 8, wherein the top plate (46) comprises a slit shaped aperture (48) joining the aperture (47) surrounding the first plate electrode (51), running to a side area of the top plate (46) and surrounding at least one of further electric leads connecting the first plate electrode (51) to the sending device (34) or at least a part of the sending device (34).

10. The system of claim 9, wherein the sending device (34) comprises an integrated circuit (35) and the slit shaped aperture (48) surrounds the integrated circuit (35).

11. The system of claim 9 or 10, wherein the top plate (46), the top side and the bottom side of the magnet (43) each have a rectangular or quadratic shape and each have corner regions, and the aperture (47) of the top plate (46) being located centrally with respect to the top plate (46) and/or the slit shaped aperture (48) extending to one of the corners of the top plate (46).

12. The system of any of claims 9 to 11, wherein at least the corner of the magnet (43) associated with the slit shaped aperture (48) is chamfered, and/or at least a part of the sending device (34) being attached to the magnet (43) in the area of its chamfered corner.

13. The system of claim 12, wherein the corner of the magnet (43) associated with the slit shaped aperture (48) is chamfered, the at least one discrete electronic component (36) being attached to the magnet (43) in the area of its chamfered corner.

14. The system of any of claims 1 to 13, further comprising a voltage-current sense device configured to sense the voltage and current of the electric leads (28), the amplifier (23) being configured to generate the electric signal in response to the sensed voltage and current.

15. A mobile device, comprising the system (21) of any of claims 1 to 14.
